# FASCICULE DE BREVET EUROPEEN

(11) **EP 0 367 679 B1**
(45) Date de publication et mention de la délivrance du brevet: **23.03.1994**
(21) Numéro de dépôt: 89403030.3
(22) Date de dépôt: 03.11.1989
(51) Int. Cl.: H01L 23/00, H05K 5/00

(54) **Procédé de protection pour assurer la tenue de composants électroniques standards aux pressions élevées**
Schutzverfahren zum Sicherstellen der Festigkeit elektronischer Standardbauteile unter erhöhten Drücken
Process for protecting electronic standard components from high pressures

(30) Priorité: 04.11.1988 FR 8814414
(43) Date de publication de la demande: 09.05.1990
(73) Titulaire: THOMSON-CSF, 75008 Paris (FR)
(72) Inventeur: Suppa, Vito, F-92045 Paris La Defense (FR)
(74) Mandataire: Desperrier, Jean-Louis

(56) Documents cités:
- DE-A- 3 311 252
- FR-A- 2 518 812
- GB-A- 2 027 272
- PATENT ABSTRACTS OF JAPAN vol. 7, no. 94 (E-171)(1239) 20 avril 1983, & JP-A-58 18944

## Description

La présente invention se rapporte aux matériels comportant des composants électroniques standards et devant être immergés, par exemple aux matériels d'exploration sous-marine.

Classiquement, on enferme les modules électroniques dans des containers qui résistent à la pression hydrostatique, les composants n'étant pas ainsi soumis à cette pression et fonctionnant correctement.

Cependant le coût du container est plus élevé que l'électronique qu'il contient parce que la plupart des composants standards qui forment l'électronique ne sont pas chers (transistors, mémoires, et...) et qu'il faut assurer un passage étanche au niveau du container pour passer les connexions électriques (technique par perles de verre).

Une technique ne nécessitant pas la mise de modules en containers résistants est connue de FR-A-2 518 812 et consiste à remplir un container non résistant par un liquide neutre vis-à-vis des composants. Les composants électroniques sont alors toutefois soumis à la pression extérieure.

Les matériels destinés à être immergés, doivent résister à la pression hydrostatique. Or les boîtiers des composants électroniques standards n'ont pas une rigidité suffisante pour résister à des pressions importantes (quelques centaines de bars).

Pour résoudre ces problèmes, le procédé de protection selon l'invention consiste à renforcer la partie supérieure des boîtiers des composants électroniques standards au moyen d'une plaque de matériau résistant à des pressions de quelques centaines de bars.

Ce procédé est défini en revendication 1, des réalisations particulières en étant définies dans les revendications dépendantes 2 et 3
D'autres particularités et avantages de l'invention apparaîtront clairement dans la description suivante faite en regard des figures annexées qui représentent :
- la figure 1 : une vue d'un module électronique protégé selon l'art antérieur,
- la figure 2 : une vue en coupe d'un transistor protégé selon l'invention,
- la figure 3 : une vue en coupe d'une mémoire protégée selon l'invention,
- la figure 4 : une vue d'un module électronique selon l'invention.

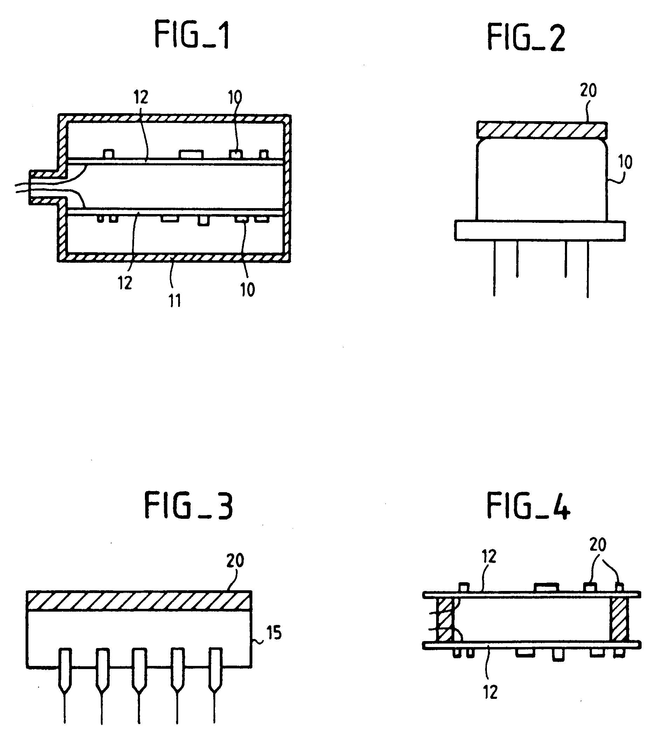

La figure 1 représente un module électronique comprenant 2 cartes, 12, sur lesquelles sont soudés les différents composants électroniques, 10, le tout étant enfermé dans un container hermétique, 11, résistant à la pression hydrostatique.

Les figures 2 et 3 représentent schématiquement respectivement un transistor, 10, et une mémoire, 15, munis d'une plaque, 20, suffisamment rigide pour résister à des pressions de plusieurs centaines de bars. Cette plaque est formée d'un matériau, par exemple du verre époxy armé qui présente des caractéristiques de rigidité intrinsèque importantes. Cette plaque est découpée aux dimensions du composent puis collée sur la surface supérieure du boitier de ce composant avec une colle en résine époxy. Cette opération de collage peut s'effectuer indifféremment avant ou après le montage des composants sur les cartes électroniques. L'expérience a montré que la rigidité à la flexion du verre époxy permet de repousser la limite de tenue en pression de façon importante puisqu'un boitier transistor standard TO99 seul supporte, sans déformation, une pression de 75 bars alors que cette limite est reculée à 400 bars lorsque le même transistor est muni d'une plaque en verre époxy d'épaisseur 1,6 mm. Au-delà de 400 bars, les côtés verticaux du boîtier s'écrasent. L'épaisseur de la plaque est fonction de la taille des composants. Elle est d'autant plus importante que la surface du boîtier est grande.

La figure 4 représente un module électronique comprenant 2 cartes, 12, sur lesquelles les différents composants électroniques sont soudés. Les surfaces supérieures des boîtiers de ces composants sont recouvertes d'une plaque en verre époxy, 20.

L'invention permet ainsi de façon simple et peu coûteuse par rapport aux prix des composants électroniques standards, de protéger ces derniers des pressions hydrostatiques plus élevées que la pression à laquelle ils tiennent sans l'invention.

## Revendications

1. Procédé de protection pour assurer la tenue des composants électroniques aux pressions élevées, dans lequel on renforce la surface supérieure des boîtiers des composants électroniques (10, 15) en venant coller sur cette surface une plaque (20) suffisamment rigide pour résister à des pressions de quelques centaines de bars.

2. Procédé selon la revendication 1, caractérisé en ce que la plaque (20) a une rigidité suffisante pour résister à une pression de 400 bars.

3. Procédé selon l'une quelconque des revendications 1 et 2, caractérisé en ce que la plaque (20) est en verre époxy.

## Claims

1. Protection method for ensuring the integrity of electronic components at high pressures, in which the upper surface of the cases of the electronic components (10, 15) are reinforced by adhesively bonding onto this surface a plate (20) which is sufficiently rigid to withstand pressures of a few hundreds of bars.

2. Method according to Claim 1, characterized in that the plate (20) has a rigidity sufficient to withstand a pressure of 400 bar.

3. Method according to either of Claims 1 and 2, characterized in that the plate (20) is made of glass-epoxy.

## Patentansprüche

1. Verfahren zum Schutz elektronischer Bauelemente gegen einen erhöhten Druck, wobei die obere Außenseite der Gehäuse der elektronischen Bauelemente (10, 15) durch Aufkleben einer ausreichend starren Platte (20) auf diese Oberfläche verstärkt wird, so daß sich eine Druckfestigkeit bis zu einigen hundert Bar ergibt.

2. Verfahren nach Anspruch 1, dadurch gekennzeichnet, daß die Platte (20) eine ausreichende Starrheit hat, um einem Druck von 400 Bar standzuhalten.

3. Verfahren nach einem beliebigen der Ansprüche 1 und 2, dadurch gekennzeichnet, daß die Platte (20) aus Epoxyglas ist.
